# EUROPEAN PATENT APPLICATION

(11) **EP 2 424 201 A2**
(43) Date of publication of application: **29.02.2012**
(21) Application number: 11155093.5
(22) Date of filing: 18.02.2011
(51) Int. Cl.: H04M 1/725

(54) **System and method to integrate ambient light sensor data into infrared proximity detector settings**

(30) Priority: 31.08.2010 US 378834 P
(71) Applicant: RESEARCH IN MOTION LIMITED, Waterloo, Ontario N2L 3W8 (CA)
(72) Inventor: Choboter, Kevin Joseph, Waterloo Ontario N2L 3W8 (CA); Broga, Antanas Matthew, Waterloo Ontario N2L 3W8 (CA); Zhou, Hong Yu, Waterloo Ontario N2L 5R9 (CA)
(74) Representative: Roberts, Gwilym Vaughan

(57) **Abstract**

A device is provided that includes an ambient light level sensor, a proximity sensing system, and a processor. The ambient light level sensor generates a signal as a function of an ambient light level at the device. The proximity sensing system comprises an emitter component. The processor is configured to receive the signal from the ambient light level sensor and to adjust an electrical current through the emitter component based on the signal.

## Description

Proximity sensing is sometimes performed to determine how close one object is to another. A typical proximity sensing system contains an emitter component and a sensor component. The emitter component is typically a light emitting diode (LED) that emits electromagnetic energy in the infrared (IR) frequency range and in a particular direction. Hereinafter, this component will be referred to as the IR LED, but it should be understood that this component might be some other type of emitter besides an LED and might emit at frequencies other than in the IR range. Similarly, hereinafter, the sensor component of a proximity sensing system will be referred to as the IR sensor, but it should be understood that this component might detect energy at frequencies other than in the IR range. The emitter component may emit, and the sensor component may detect, a quantity other than electromagnetic radiation, such as sound; but for simplicity the concepts will be described in terms of light being emitted and detected.

If an object is near the IR LED in the direction in which the IR LED is emitting, some of the IR energy from the IR LED will reflect from the object toward the IR LED. The sensor component of a proximity sensing system is typically located near the IR LED and can measure the strength of the returning IR energy. The proximity sensing system can then correlate the strength of the returning IR energy to the distance of the object from the proximity sensing system. That is, a higher level of returning IR energy indicates that the object is relatively close, and a lower level of returning IR energy indicates that the object is relatively far. In some cases, two measurements may be made. The first takes a measurement without the IR LED on, so as to gauge the ambient IR level. The second measurement is taken with the IR LED on, and the ambient IR measurement from the first measurement is subtracted.

A system that includes an IR LED and an IR sensor or a system with components that perform similar functions will be referred to herein as a proximity sensing system. A proximity sensing system may include components in addition to the IR LED and the IR sensor, and any action described herein as being taken by the system should be understood as being taken by any combination of components in the system.

### BRIEF DESCRIPTION OF THE DRAWINGS

For a more complete understanding of this disclosure, reference is now made to the following brief description, taken in connection with the accompanying drawings and detailed description, wherein like reference numerals represent like parts.

Figure 1 illustrates a device that includes a touch screen and a proximity sensing system, according to an embodiment of the disclosure.

Figure 2 is a table correlating brightness categories, light level ranges, IR LED currents, and IR sensor gains, according to an embodiment of the disclosure.

Figure 3 is a table correlating brightness categories with noise floor adjustments, according to an embodiment of the disclosure.

Figure 4 illustrates a method for adjusting IR LED current, according to an embodiment of the disclosure.

Figure 5 illustrates a processor and related components suitable for implementing the several embodiments of the present disclosure.

### DETAILED DESCRIPTION

It should be understood at the outset that although illustrative implementations of one or more embodiments of the present disclosure are provided below, the disclosed systems and/or methods may be implemented using any number of techniques, whether currently known or in existence. The disclosure should in no way be limited to the illustrative implementations, drawings, and techniques illustrated below, including the exemplary designs and implementations illustrated and described herein, but may be modified within the scope of the appended claims along with their full scope of equivalents.

Proximity sensing systems are sometimes used in handheld devices that have touch screens (and may also be used in devices that lack touch screens). As used herein, the terms "device", "electronic device", and the like can refer to mobile equipment such as telephones, smart phones, personal digital assistants, handheld computers, and similar devices. A touch screen is a display screen on such a device that can accept inputs by means of physical contact with the screen by a device user. The following discussion will focus on the use of proximity sensing systems in devices with touch screens and telecommunications capabilities, but it should be understood that the embodiments disclosed herein may be applicable in other situations.

When a user brings a device with a touch screen near the user's face, for example to make a phone call, the user might unintentionally cause contact between the touch screen and the user's face. The contact might produce an input that causes the call to be disconnected or muted or might produce some other undesirable response. To prevent such inadvertent inputs, the device can be equipped with a proximity sensing system. When the proximity sensing system detects that it is near an object, the device can assume that the device is near the user's face ("near" can be any distance defined at any time prior to the proximity sensor's determination) and can disable the capability of the touch screen to accept inputs. When the proximity sensing system detects that it is no longer near the object, the system can assume that the device has been moved away from the user's face and can re-enable the touch screen's input acceptance functionality. As already mentioned, proximity sensing may play a role in other situations as well.

Handheld or portable devices might be used in a wide range of lighting conditions, from dark rooms to bright sunshine. Bright ambient light that contains a large IR spectrum can interfere with the ability of the proximity sensing system on such a device to correctly measure the distance to nearby objects. Therefore, the IR LED in the proximity sensing system is typically driven at a relatively high current so that it emits sufficient IR energy to overcome the effects of bright ambient light that contains a large IR spectrum. While this high current can compensate for the worst-case scenario of bright outdoor light, a high IR LED current can be wasteful in dimmer lighting conditions where the IR LED may not need to emit high levels of IR energy in order for the proximity sensing system to work properly. Also, when the IR LED is operated at a high current, some of the energy it emits in the visible spectrum can become strong enough to be visible to the user. The visible blinking of the IR LED can be distracting or annoying to the user and may therefore be undesirable. (It may be noted that the use of units of amperes or "amps"—which are units of electrical current―is a matter of convenience and that conversion to other units is possible.)

In an embodiment, a plurality of brightness categories are defined and are correlated to a plurality of ranges of possible ambient light levels. The actual ambient light level for a device is measured and placed in the corresponding brightness category. The current at which the IR LED in a proximity sensing system on the device is driven is then adjusted based on the device's brightness category. In brighter categories, the current can remain at or near the traditional high levels to prevent the IR LED from being overwhelmed by the high IR content of bright ambient light. In dimmer categories, the IR LED current can be reduced to save power and to reduce the visibility of the IR.

In an embodiment, the brightness categories are determined by an ambient light sensor that is already present on the device. That is, many devices are equipped with ambient light sensors that allow automated adjustments to be made to the brightness of the device's display screen, keypad, and other components. When the ambient light sensor detects that the device is in bright light, the ambient light sensor might cause the display screen to become brighter so that it can be more easily seen. When the ambient light sensor detects that the device is in dim light, the ambient light sensor might cause the display screen to become dimmer so that it is not annoyingly bright and to save power. A keypad backlight might also be turned on. In an embodiment, the light level detected by the ambient light sensor is used to determine the brightness category currently applicable to the device. The brightness category might then be used to determine an adjustment to the current at which the IR LED is driven.

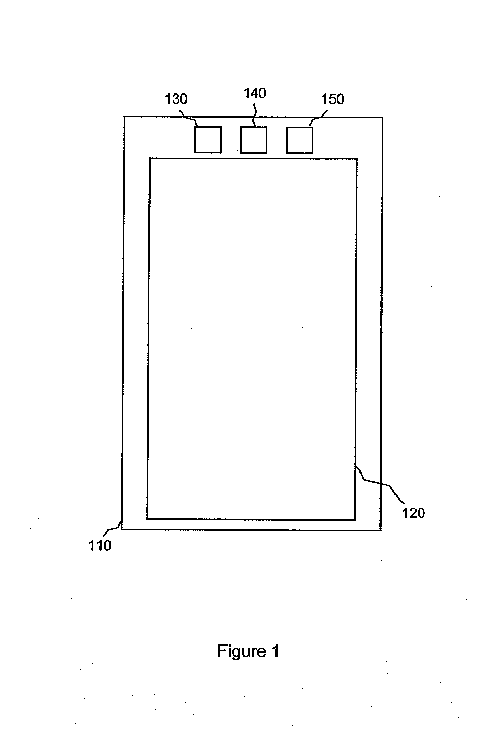

Figure 1 illustrates an embodiment of a device 110 in which such an IR LED current adjustment technique might be used. The device 110 includes a touch screen 120, an IR LED 130, an IR sensor 140, and an ambient light sensor 150. While the IR LED 130, IR sensor 140, and ambient light sensor 150 are depicted near one another and near the top of the device 110, in other embodiments these components could be in other locations on the device 110 and in other spatial relationships with one another. The IR sensor 940 and the ambient light sensor 150 can be combined to be in the same integrated circuit, although they may remain separate sensors. Also, it should again be understood that, while the IR LED 130, IR sensor 140, and ambient light sensor 150 are depicted in a telecommunications device with a touch screen, these components could function as described herein in other types of devices.

Information about the current ambient light level for the device 110 is provided by the ambient light sensor 150 to a processing component or processor (not shown in Figure 1) on the device 110. The processing component then determines a brightness category that corresponds to the ambient light level. The processing component then specifies, based on the brightness category, the current at which the IR LED 130 is to be driven. The ambient light sensor 150 may be any kind of sensor that responds to different levels of ambient light. Typically, the ambient light sensor 150 generates an electrical signal as a function of the detected ambient light, and the processing component determines a brightness category as a function of that electrical signal.

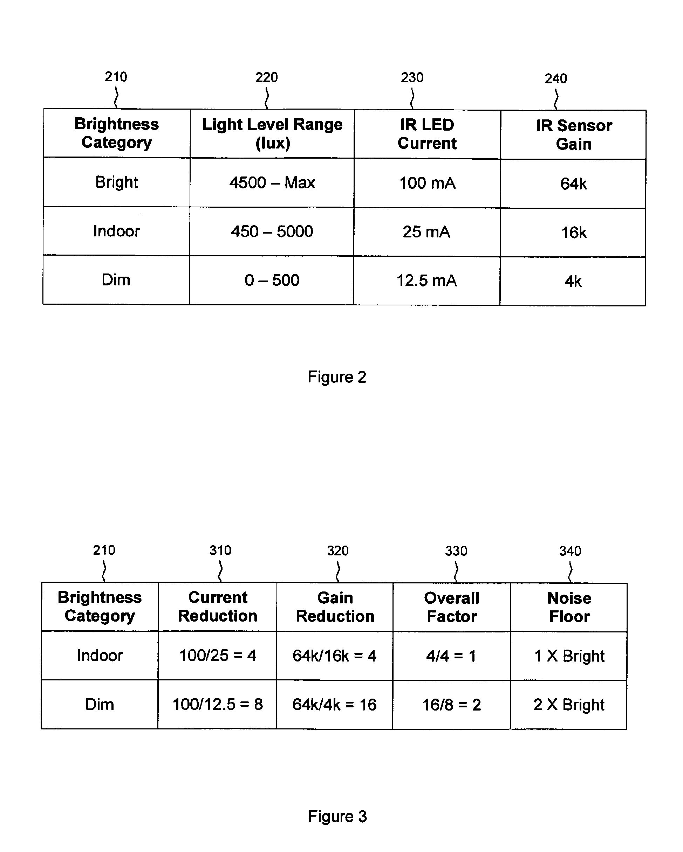

Figure 2 illustrates an example of different brightness categories that might be defined to correspond to different light levels. In this example, three brightness categories are defined, as shown in column 210, but in other embodiments other numbers of brightness categories could be used. Light level ranges that can correspond to these brightness categories are shown in column 220. In this example, a light level range of 0 - 500 lux is defined to correspond to a dim brightness category, a light level range of 450 - 5000 lux is defined to correspond to an indoor brightness category, and a light level range of 4500 lux or greater is defined to correspond to a bright brightness category. In other embodiments, other light level ranges could be defined to correspond to these or other brightness categories.

In an embodiment, the brightness categories in column 210 are associated with the IR LED currents shown in column 230. That is, when the ambient light level is in the bright brightness category, the IR LED current is 100 milliamps (mA), as is traditionally the case. When the ambient light level is in the indoor brightness category, the IR LED current is set at 25 mA, and when the ambient light level is in the dim brightness category, the IR LED current is set at 12.5 mA. In other embodiments, other IR LED current levels could be specified for these or other brightness categories. Also, it should be understood that the brightness categories might be defined merely for the sake of convenience. The measured ambient light levels could be correlated directly to IR LED currents without the intermediate step of conversion into brightness categories. In addition, instead of ranges of ambient light levels being correlated to discontinuous IR LED current values, a continuous function could be used to convert ambient light levels to IR LED currents. Information such as that depicted of the table of Figure 2 may be stored in a memory element of the device 110 (as discussed below) and made available to the processor. It is also possible that the information may be embodied as instructions executed by the processor or may be embodied in the processor's hardware.

The IR sensor of a proximity sensing system is typically operated at a relatively high gain when a relatively high current is used in the IR LED component. For example, at the 100 mA IR LED current that is traditionally used for proximity sensing systems in devices with touch screens, a gain of 64k is typically used for the IR sensor.

In an embodiment, the gain of the IR sensor in a proximity sensing system is adjusted when the current at which the IR LED in the system is driven is adjusted. More specifically, as the IR LED current is decreased, the gain of the IR sensor is also decreased. A decrease in the gain of the IR sensor corresponds to an increase in the sensitivity of the IR sensor, since the range over which the iR sensor operates is decreased. In general, a quantity such as an electrical current is adjusted when it is set or changed from a previous value.

Examples of IR sensor gains that might be associated with various IR LED current levels are shown in column 240 of Figure 2. In this case, the 100 mA IR LED current used in the bright brightness category is associated with an IR sensor gain of 64k, as is traditionally the case. The 25 mA IR LED current used in the indoor brightness category is associated with an IR sensor gain of 16k. The 12.5 mA IR LED current used in the dim brightness category is associated with an IR sensor gain of 4k. In other embodiments, other IR sensor gains could be specified for these or other IR LED currents.

The IR sensor of a proximity sensing system will typically detect some amount of IR energy even when the proximity sensing system is not near an object that is reflecting IR energy from the IR LED back to the IR sensor. IR energy from ambient light, IR energy that is bleeding over from the IR LED directly into the IR sensor without reflection, different internal characteristics of different proximity sensing systems, and other factors can contribute to the IR sensor measuring some level of incoming IR energy that was not emitted from the IR LED. To compensate for such factors, a quantity known as the noise floor is typically determined for a proximity sensing system and is used to adjust the IR energy measurements made by the system. Since such factors can differ in different devices, a noise floor may be calculated individually for each different device that uses a proximity sensing system. The calculation is typically made at the time of manufacture of the device in conditions that are similar to the conditions the device might be expected to encounter during actual use. The calculated noise floor can then be stored on the device and subtracted from any measurements of IR energy made by the proximity sensing system.

In an embodiment, the noise floor of a proximity sensing system is adjusted when a brightness-based adjustment is made to the IR LED current of the system. Figure 3 illustrates an example of how such a noise floor adjustment could be made using the current reductions and gain reductions of Figure 2. For the indoor brightness category, it can be seen in column 310 that a current reduction of a factor of 4 is calculated compared to the bright brightness category. That is, the 100 mA current used in the bright brightness category is adjusted to 25 mA in the indoor brightness category, resulting in a current reduction factor of 4. Similarly, the 64k gain used in the bright brightness category is adjusted to 16k in the indoor brightness category, resulting in a gain reduction factor of 4, as shown in column 320. An overall noise floor adjustment factor can then be calculated by dividing the gain reduction factor, 4 in this case, by the current reduction factor, also 4 in this case. As shown in column 330, this gives a noise floor adjustment factor of 1, meaning that the factory-established noise floor for this proximity sensing system is multiplied by 1. In other words, in this case, no adjustment is made to the noise floor that was established at the factory for bright conditions. While not shown in Figure 3, it should be understood that there would be no adjustment to the factory-established noise floor in the case of the bright brightness category.

In the case of the dim brightness category, a different noise floor adjustment factor might be calculated. In the examples of Figure 2, it can be seen that the 100 mA current used in the bright brightness category is adjusted to 12.5 mA in the dim brightness category, resulting in a current reduction factor of 8, as shown in column 310 of Figure 3. The 64k gain used in the bright brightness category is adjusted to 4k in the dim brightness category, resulting in a gain reduction factor of 16, as shown in column 320. The overall noise floor adjustment factor can then be calculated by dividing the gain reduction factor, 16 in this case, by the current reduction factor, 8 in this case. This gives a noise floor adjustment factor of 2, as shown in column 330. This means that, as shown in column 340, the noise floor established for bright conditions is multiplied by 2 when ambient light in the dim brightness category is detected. In other embodiments, the noise floor adjustment factor could be calculated in other ways.

In some cases, the ambient light sensor on a device may become blocked by an action taken by the device user. For example, if the ambient light sensor is located near the speaker of a telecommunications device, when the user of the device places the speaker near the user's ear while making a call, the ambient light sensor could be at least partially covered by the user's ear or another part of the user's head. This could cause a decrease in the amount of light detected by the ambient light sensor. The ambient light sensor may have no way to detect whether a detected decrease in the light level has been caused by such a blockage or by an actual decrease in the ambient light level An assumption that all detected decreases are caused by actual decreases in the ambient light level could be erroneous. Such an error may cause the processor to incorrectly identify the brightness category to which the ambient light currently belongs. For instance, a blockage could cause the ambient light sensor to place the ambient light level in the dim brightness category when the device is actually in bright light.

If an adjustment were to be made to the IR LED current based on an erroneous brightness level detection, the proximity sensing system may not function properly. For example, if a reduction in the detected light level caused by a blockage of the ambient light sensor were to cause the IR LED current to be reduced when the device is actually in bright light, the proximity sensing system may become overwhelmed by the ambient light and consequently the processor may incorrectly determine that the device is far from the user's face. The processor may then mistakenly allow the touch screen on the device to accept inputs, and this could allow erroneous inputs to be made as described above.

In an embodiment, the acceptance of inadvertent inputs in such cases is prevented through the use of proximity zones. In some embodiments, two proximity zones, which can be referred to as "close" and "far", are defined and refer, respectively, to situations where a device is relatively close to a user or relatively far from a user. In some cases, the close and far proximity zones correspond to the distances traditionally used in disabling and enabling the capability of a touch screen to accept inputs. In other cases, the close and far proximity zones can be defined differently from those distances.

In an embodiment, when a device is in the close proximity zone and the ambient light sensor on the device detects a decrease in ambient light, no change is made to the device's brightness category at that time. The device is placed in a dimmer brightness category only when the proximity sensing system detects that the device is in the far proximity zone and the ambient light sensor detects that a dimmer brightness category is appropriate for the ambient light. If the ambient light sensor detects that the ambient light increases when the device is moved to the far proximity zone, the ambient light sensor can assume that it was previously being blocked, and the ambient light can remain in a brighter brightness category. These steps can prevent the processor from determining that the device has moved into a relatively dimmer brightness category when, in fact, the ambient light sensor has simply become blocked.

Several examples may clarify the operation of the proximity sensing system and the ambient light sensor in such situations. In a first example, a user makes a call on a device that is in the bright brightness category. The proximity sensing system on the device detects that the user is in the close proximity zone since the device is close to the user's head. If the user remained in the bright environment but performed some action that blocked the ambient light sensor, the ambient light sensor would detect a decrease in brightness. However, in an embodiment, no change is made to the IR LED current at that time, since the device is in the close proximity zone. That is, the IR LED current remains at the high level appropriate for the bright brightness category. If the user remained in the bright environment but later removed the blockage, the device would still be in the bright brightness category, as would be appropriate. If the IR LED current had been decreased when the decrease in brightness was detected, the IR LED current would be too low when the blockage was removed in the bright environment.

In a second example, a user again makes a call on a device that is in the bright brightness category. If the user then moved into an environment where the dim brightness category is appropriate, the ambient light sensor would again detect a decrease in brightness. ln this case, a change from the bright brightness category to the dim brightness category might be appropriate, but as in the previous example, no change is made to the IR LED current at that time, since the device is in the close proximity zone. That is, the IR LED current remains at the high level appropriate for the bright brightness category. This may cause the IR LED to be driven at a higher current than necessary in these circumstances, but it prevents an inappropriate transition to the dim brightness category in the circumstances of the first example. If the user, while still in the dim environment, moves the device into the far proximity zone, the brightness category can be changed to dim at that time, since a blockage of the ambient light sensor would be unlikely in the far proximity zone and it would thus be likely that the previously detected decrease in the light level had been caused by an actual decrease in ambient light.

Similar considerations might apply to changes in detected light levels that could involve apparent changes from the bright brightness category to the indoor brightness category or from the indoor brightness category to the dim brightness category. In general, when a decrease in ambient light is detected while the device is in the close proximity zone, no decrease is made to the IR LED current until the proximity sensing system detects that the device is in the far proximity zone. When the device is in the far proximity zone, it can be assumed that no blockage is occurring to the ambient light sensor and that the sensor measurements are therefore correct. Changes to the IR LED current can then be made or not made as appropriate for the ambient light level in the far proximity zone.

Such a technique might not be necessary in situations where a device moves from a relatively dimmer brightness category to a relatively brighter brightness category. In such situations, if the ambient light sensor detects an increase in ambient light, the processor can - in effect - assume that the ambient light sensor is not being blocked and is properly detecting the ambient light. An increase in the IR LED current might be appropriate in such a case.

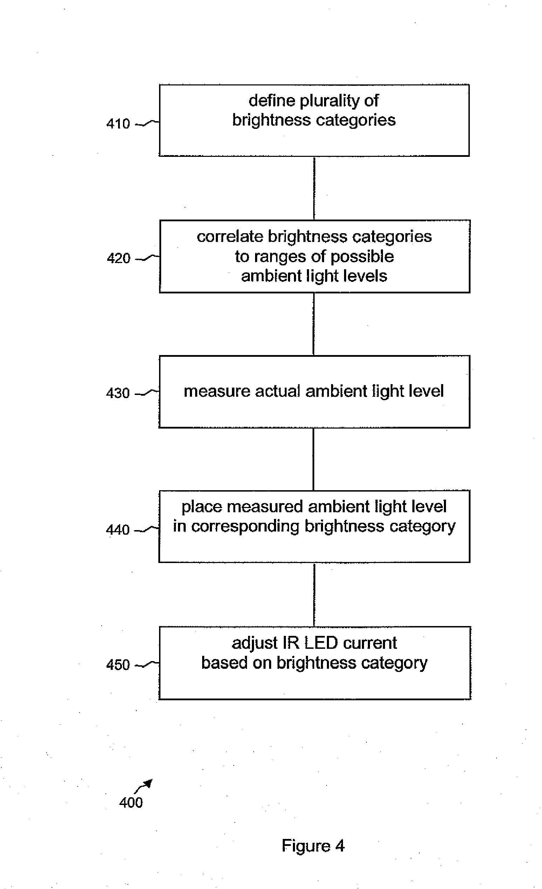

Figure 4 illustrates an embodiment of a method 400 for adjusting the current through an IR LED in a proximity sensing system. It should be understood that all of the steps shown do not necessarily need to occur and that the steps do not necessarily need to occur in the order shown. For purposes of convenience, the steps may be described as being performed by processor acting in conjunction with an ambient light sensor and a proximity sensing system. At block 410, a plurality of brightness categories are defined. At block 420, the brightness categories are correlated to ranges of possible ambient light levels. As indicated above, these brightness categories may be defined and correlated to ranges of ambient light levels before the method 400 begins. At block 430, an actual ambient light level is measured. In general, the ambient light sensor may generate a signal as a function of the ambient light, and the processor may determine the ambient light level as a function of the signal. Measurement may include, but does not necessarily include, assigning a precise light level to the ambient light. At block 440, the measured ambient light level is placed in a corresponding brightness category. In other words, the processor determines what brightness category corresponds to the ambient light level. At block 450, the processor adjusts a current at which the IR LED is driven based on the brightness category. The processor may adjust the current by, for example, regulating the current through the emitter component directly or by directing another element such as a driver to adjust the current to the emitter component. Although not shown in Figure 4, the processor may perform other actions (such as disabling the capability of a touch screen to accept inputs, as described above) when measurements made with the proximity sensing system indicate that the device is proximate to a user's face. Further, the processor may adjust sensor gain of a sensor component of the proximity sensing system based on the current through the emitter component, as described above.

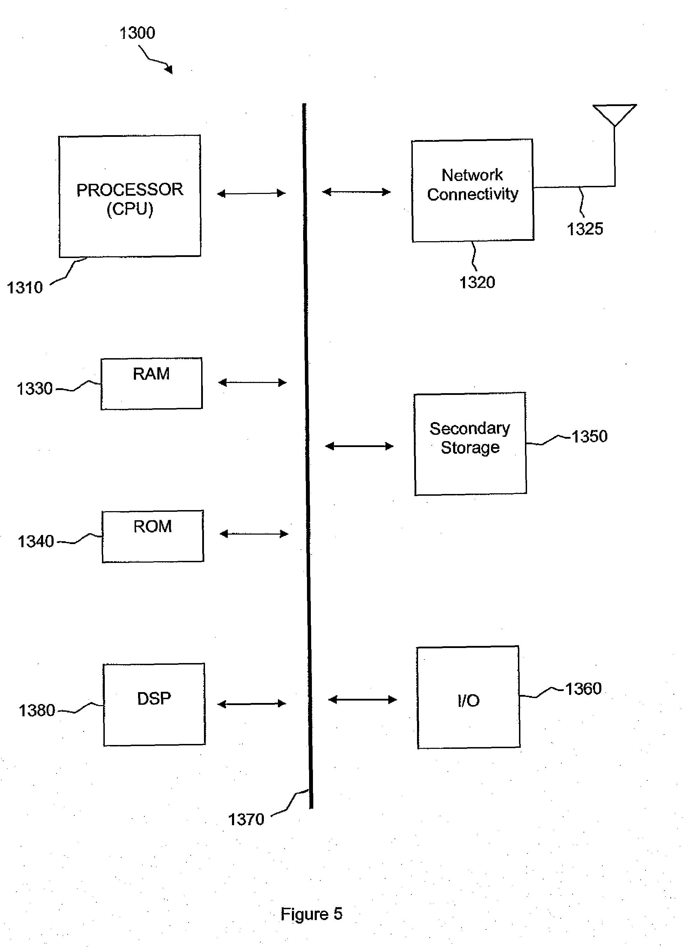

The device 110 described above might include a processing component or processor that is capable of executing instructions related to the actions described above. Figure 5 illustrates an example of a system 1300 that includes a processing component 1310 suitable for implementing one or more embodiments disclosed herein. In addition to the processor 1310 (which may be referred to as a central processor unit or CPU), the system 1300 might include network connectivity devices 1320, random access memory (RAM) 1330, read only memory (ROM) 1340, secondary storage 1350, and input/output (l/O) devices 1360. These components might communicate with one another via a bus 1370. In some cases, some of these components may not be present or may be combined in various combinations with one another or with other components not shown. These components might be located in a single physical entity or in more than one physical entity. Any actions described herein as being taken by the processor 1310 might be taken by the processor 1310 alone or by the processor 1310 in conjunction with one or more components shown or not shown in the drawing, such as a digital signal processor (DSP) 1380. Although the DSP 1380 is shown as a separate component, the DSP 1380 might be incorporated into the processor 1310.

The processor 1310 executes instructions, codes, computer programs, or scripts that it might access from the network connectivity devices 1320, RAM 1330, ROM 1340, or secondary storage 1350 (which might include various disk-based systems such as hard disk, floppy disk, or optical disk). While only one CPU 1310 is shown, multiple processors may be present. Thus, while instructions may be discussed as being executed by a processor, the instructions may be executed simultaneously, serially, or otherwise by one or multiple processors. The processor 1310 may be implemented as one or more CPU chips.

The network connectivity devices 1320 may take the form of modems, modem banks, Ethernet devices, universal serial bus (USB) interface devices, serial interfaces, token ring devices, fiber distributed data interface (FDDI) devices, wireless local area network (WLAN) devices, radio transceiver devices such as code division multiple access (CDMA) devices, global system for mobile communications (GSM) radio transceiver devices, worldwide interoperability for microwave access (WiMAX) devices, digital subscriber line (xDSL) devices, data over cable service interface specification (DOCSIS) modems, and/or other well-known devices for connecting to networks. These network connectivity devices 1320 may enable the processor 1310 to communicate with the internet or one or more telecommunications networks or other networks from which the processor 1310 might receive information or to which the processor 1310 might output information.

The network connectivity devices 1320 might also include one or more transceiver components 1325 capable of transmitting and/or receiving data wirelessly in the form of electromagnetic waves, such as radio frequency signals or microwave frequency signals. Alternatively, the data may propagate in or on the surface of electrical conductors, in coaxial cables, in waveguides, in optical media such as optical fiber, or in other media. The transceiver component 1325 might include separate receiving and transmitting units or a single transceiver. Information transmitted or received by the transceiver component 1325 may include data that has been processed by the processor 1310 or instructions that are to be executed by processor 1310. Such information may be received from and outputted to a network in the form, for example, of a computer data baseband signal or signal embodied in a carrier wave. The data may be ordered according to different sequences as may be desirable for either processing or generating the data or transmitting or receiving the data. The baseband signal, the signal embedded in the carrier wave, or other types of signals currently used or hereafter developed may be referred to as the transmission medium and may be generated according to several methods well known to one skilled in the art.

The RAM 1330 might be used to store volatile data and perhaps to store instructions that are executed by the processor 1310. The ROM 1340 is a non-volatile memory device that typically has a smaller memory capacity than the memory capacity of the secondary storage 1350. ROM 1340 might be used to store instructions and perhaps data that are read during execution of the instructions. Access to both RAM 1330 and ROM 1340 is typically faster than to secondary storage 1350. The secondary storage 1350 is typically comprised of one or more disk drives or tape drives and might be used for non-volatile storage of data or as an over-flow data storage device if RAM 1330 is not large enough to hold all working data. Secondary storage 1350 may be used to store programs that are loaded into RAM 1330 when such programs are selected for execution.

The 1/0 devices 1360 may include liquid crystal displays (LCDs), touch screen displays, keyboards, keypads, switches, dials, mice, track balls, track pads, voice recognizers, card readers, paper tape readers, printers, video monitors, or other well-known input/output devices. Also, the transceiver 1325 might be considered to be a component of the 1/0 devices 1360 instead of or in addition to being a component of the network connectivity devices 1320.

In an embodiment, a method for operating a proximity sensing system is provided. The method includes measuring an ambient light level and adjusting an electrical current through an emitter component of the proximity sensing system based on the measured ambient light level.

In another embodiment, a device is provided that includes an ambient light level sensor, a proximity sensing system, and a processor. The ambient light level sensor generates a signal as a function of an ambient light level at the device. The proximity sensing system comprises an emitter component. The processor is configured to receive the signal from the ambient light level sensor and to adjust an electrical current through the emitter component based on the signal.

In another embodiment, a proximity sensing system is provided. The proximity sensing system includes an emitter component configured to be driven at an adjustable electrical current. The value of the current is based on an ambient light level measured at the proximity sensing system.

While several embodiments have been provided in the present disclosure, it should be understood that the disclosed systems and methods may be embodied in many other specific forms without departing from the spirit or scope of the present disclosure. The present examples are to be considered as illustrative and not restrictive, and the intention is not to be limited to the details given herein. For example, the various elements or components may be combined or integrated in another system or certain features may be omitted, or not implemented.

Also, techniques, systems, subsystems and methods described and illustrated in the various embodiments as discrete or separate may be combined or integrated with other systems, modules, techniques, or methods without departing from the scope of the present disclosure. Other items shown or discussed as coupled or directly coupled or communicating with each other may be indirectly coupled or communicating through some interface, device, or intermediate component, whether electrically, mechanically, or otherwise. Other examples of changes, substitutions, and alterations are ascertainable by one skilled in the art and could be made without departing from the spirit and scope disclosed herein.

## Claims

1. A method for operating a proximity sensing system, comprising:
measuring an ambient light level; and
adjusting an electrical current through an emitter component of the proximity
sensing system based on the measured ambient light level.

2. A device, comprising:
an ambient light level sensor that generates a signal as a function of an ambient
light level at the device;
a proximity sensing system, the proximity sensing system comprising an emitter
component; and
a processor configured to receive the signal from the ambient light level sensor and
to adjust an electrical current through the emitter component based on the signal.

3. A proximity sensing system, comprising:
an emitter component configured to be driven at an adjustable electrical current, the
value of the current being based on an ambient light level measured at the proximity sensing system.

4. The method, device, or proximity sensing system of claims 1, 2, and 3, wherein the proximity sensing system is used in a wireless telecommunications device to determine a proximity of the device to a user of the device such that inputs into a touch screen on the device are disabled when the touch screen is within a predefined distance of the user's face.

5. The method, device, or proximity sensing system of claim 4, wherein the ambient light level is measured by an ambient light level sensor on the device, the ambient light level further used to determine an adjustment of the brightness of at least one of a display screen on the device and a keypad backlight on the device.

6. The method, device, or proximity sensing system of claims 1, 2, and 3, wherein the measured ambient light level is placed in an ambient light level category corresponding to a range in which the measured ambient light level falls, and wherein the current through the emitter component of the proximity sensing system is adjusted based on the ambient light level category in which the measured ambient light level is placed, lower current levels being associated with dimmer ambient light level categories.

7. The method, device, or proximity sensing system of claim 6, wherein a sensor gain of a sensor component of the proximity sensing system is adjusted based on the current through the emitter component, lower gain levels being associated with lower current levels.

8. The method, device, or proximity sensing system of claim 7, wherein a noise floor for the proximity sensing system is adjusted based on the adjusted emitter current and the adjusted sensor gain.

9. The method, device, or proximity sensing system of claim 8, wherein an emitter current reduction factor is calculated by dividing a default emitter current by the adjusted emitter current, and wherein a sensor gain reduction factor is calculated by dividing a default sensor gain by the adjusted sensor gain, and wherein a noise floor adjustment factor is calculated by dividing the sensor gain reduction factor by the emitter current reduction factor.

10. The method, device, or proximity sensing system of claim 5, wherein, when the device is within the predefined distance of the user's face and the ambient light sensor on the device detects a decrease in the ambient light level, no change is made to the emitter component's current unless the proximity sensing system later detects that the device is outside the predefined distance from the user's face.
